# EUROPEAN PATENT APPLICATION

(11) **EP 1 091 628 A2**
(43) Date of publication of application: **11.04.2001**
(21) Application number: 00308767.3
(22) Date of filing: 05.10.2000
(51) Int. Cl.: H05K 7/10

(54) **Electrical interconnection socket apparatus**

(30) Priority: 06.10.1999 JP 28509599
(71) Applicant: Texas Instruments Incorporated, Dallas, Texas 75251 (US)
(72) Inventor: Sano, Hideki, Gotenba-shi, Shizuoka (JP)
(74) Representative: Legg, Cyrus James Grahame

(57) **Abstract**

A socket (1, 1A) for connecting an IC chip package (6) with an external circuit. A positioning surface (23a, 230a) for positioning IC chip package (6) is provided on the side of the top (2b) of base (2, 2A) and a mounting hole (22) for mounting contact member (4, 4', 4A) is provided opening to the side (2c) of the base. A mounting leg (40) of each contact member (4, 4', 4A) is capable of being inserted from the side (2c) of base (2, 2A) into a mounting hole (22) of the base. Mounting leg (40) forms one leg of a generally U-shaped central portion of contact member (4, 4', 4A) with the other base leg (41), from which lead (42) extends, capable of flexing to conform to deflection of the circuit board (7) upon being subjected to downwardly directed forces used in depressing cover (3).

## Description

### Field of the Invention

This invention relates generally to a socket for removably loading an electrical part having a large number of terminal leads and electrically connecting each lead of the part to an external device and more particularly to a socket for burn-in tests and the like of IC packages such as TSOP's and QFP's.

### Background of the Invention

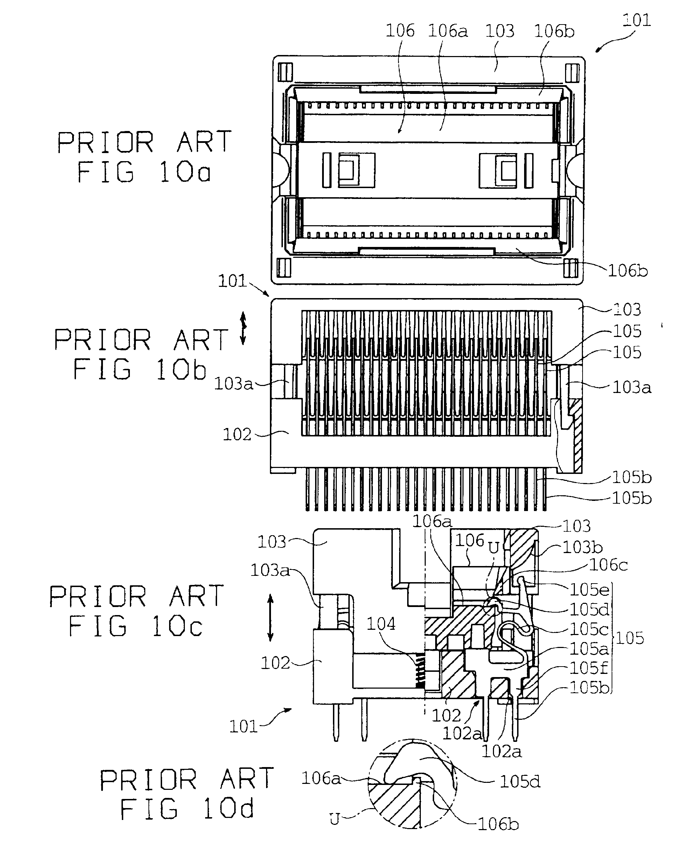

In discussing the prior art, reference will be made to Figs 10a-10d, 11a-11d, 12a and 12b. As shown in Figs. 10a through 10c, prior art socket 101, used in the testing of an IC chip (not shown in the drawings), has a molded plastic base 102 and an operating cover 103 disposed on the base formed with an opening which is somewhat larger than the outside dimensions of the IC chip package to be inserted. Operating cover 103 is vertically movable relative to base 102 and biased away from the base by a spring 104. A plurality of electrically conductive contact members 105, made of sheet metal, one for each of the leads of the IC chip packages to be tested, are mounted on base 102. Each contact member 105 has a base 105a and a lead 105b which extends downwardly from the base in a straight line for receipt through a mounting hole in base 102. Contact member 105 is fixed to the base 102 with lead 105b projecting beyond the bottom of base 102 in a vertical direction from a mounting part 105f in base 102. Each contact member 105 has a spring part 105c which extends from base 105a in a sinuous curve to first and second bifurcated parts. The tip of the first bifurcated part is formed as a contact 105d for engaging an IC lead and the tip of the second part is formed with a cam follower end 105e that is capable of engaging operating cover 103.

An adaptor 106 having a seating surface 106a for receipt of an IC chip package thereon is mounted on the top of base 102. A protruding lip 106b (see Fig. 10d) is formed at the edge of seating surface 106a of adaptor 106 for positioning a terminal of an IC lead. A protective wall portion 106c in the shape of a beveled surface is formed above seating surface 106a of adaptor 106 to prevent a lead of an IC chip package from entering a slot in the operating cover 103. When operating cover 103 is pressed downwardly, cam 103b, formed in the shape of a curved surface inside operating cover 103, engages follower end 105e of the contact member to concomitantly move contact 105d of contact member 105 away from lip 106b of adaptor 106. When the downward force on the operating cover is removed, contact 105d of contact member 105 engages a respective IC lead on seating surface 106a of adaptor 106 due to the force of spring 105c, thereby effecting an electric connection therebetween.

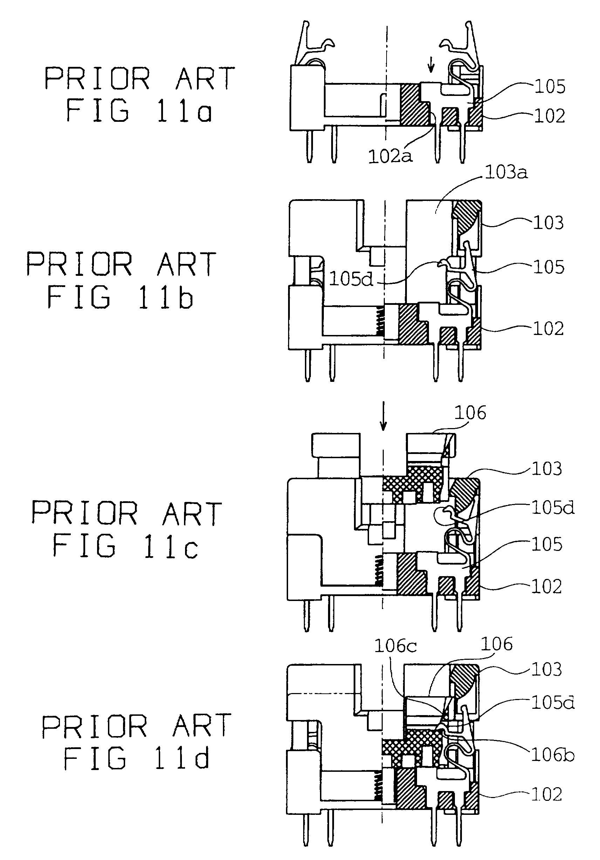

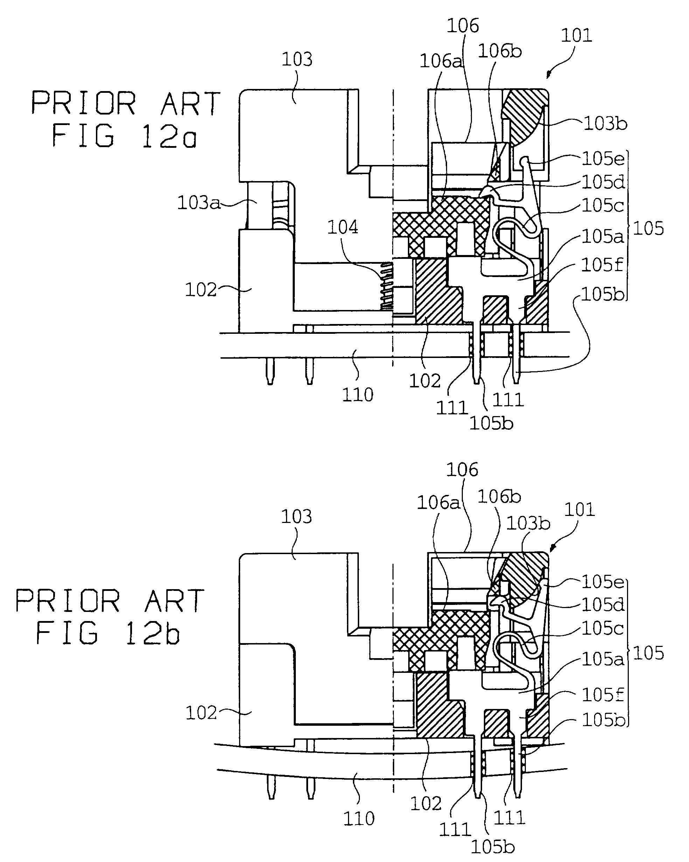

When the prior art socket 101 made as described above is to be assembled, each contact member 105 is fixed to base 105 by being pressed into a respective mounting hole 102a from above base 102 as shown in Fig. 11a. Operating cover 103 is then installed on base 102 as shown in Fig. 11b. Thereafter, when operating cover 103 is pressed downwardly, contact 105d of each contact member 105 is moved away from the IC seating surface and adaptor 106 is inserted into opening 103a of operating cover 103 for attachment to base 102, as shown in Figs. 11c and 11d. Socket 101, assembled as described, is loaded on circuit substrate 110 (Fig. 12a) and lead 105b of each contact member that extends from the lower surface is soldered to a connective terminal 111 of circuit substrate 110.

However, a prior art socket made as described above has the following problem. As noted, contact members 105 are pressed in from above base 102 as shown in Fig. 11a. Therefore, the space where contact members 105 pass through in connection with their insertion overlaps the space where the adaptor is set. Accordingly, it is difficult to provide seating surface 106a for the IC chip and positioning lip 106b for the IC lead integrally with base 102. Therefore, adaptor 106 for positioning of the IC chip is formed as a separate member from base 102, thereby increasing the number of parts and assembling steps required. According to the prior art socket described above, moreover, when operating cover 103 is pressed down, as shown in Fig. 12b, a load is placed on circuit substrate 110 through contact members 105 mounted in base 102 which cause a deflection of substrate 110 and concomitant torsional forces on the soldered joints of leads 105b and terminals 111 of the substrate. Accordingly, there has been a problem of reliability with regard to electrical continuity due to separation of the joint between leads 105b of contact members 105 and circuit substrate 110 or a loosening of the installation part 105f of contact members 105.

A socket has also been proposed having contact members capable of electrical engagement with the top and bottom of the IC leads with the IC leads sandwiched by two contact parts to provide improved reliability of electrical connection between the IC leads and respective contact members. In a socket where such a contact member having two contact parts is used, however, the possibility of incursion of IC leads on the adaptor into spaces between the contacts is increased with the elimination of lip106b.

### Summary of the Invention

An object of the present invention is the provision of a socket which overcomes the above noted problems and limitations in the prior art. Another object of the invention is the provision of a socket in which the separate adaptor member for positioning and seating the IC package is omitted, thereby reducing the number of parts of the socket and the assembling steps required. Another object of the invention is the provision of a socket having high electrical continuity reliability of maintaining contact member engagement between the electrically conductive members and the external circuit. Still another object of the invention is the provision of a socket employing contact members each having two contact parts for sandwiching respective IC terminals which overcome the prior art IC terminal incursion problems noted above.

Briefly stated, a socket for connecting an IC chip having a plurality of terminals to an external circuit through electrically conductive contact members made in accordance with the invention comprises a base having a seating surface for seating an IC package at a top part of the base and having transversely extending mounting holes formed in a side of the base for receiving a mounting leg of respective electrically conductive contact members. An operating member capable of moving relative to the base operates the electrically conductive contact member by engaging the contact member in a manner similar to the prior art by camming a follower portion thereof. The electrically conductive contact members are each provided with a lead extending from a base leg of a central portion for connection to the external circuit, the base leg being capable of flexing relative to a mounting leg of the central portion in a direction which is approximately parallel with the direction of movement of the operating member relative to the mounting leg. The mounting holes in the socket body for the contact members extend in a direction which crosses, approximately at a right angle, the direction in which the operating member moves and the mounting leg of each electrically conductive contact member is formed so as to be pressed into a mounting hole of the socket body in a forced fit. According to a feature of the invention, there is provided an incursion blocking part for preventing the incursion of the terminal leads of an IC element among the electrically conductive contact members. According to yet another feature of one preferred embodiment of the invention, the electrically conductive contact members each have first and second contacts capable of contacting a respective IC terminal lead in such a way as to sandwich the terminal lead. According to another feature, the width of the lower, or second, contact is widened to effectively eliminate the possibility of any incursion of IC terminal leads among adjacent electrically conductive contact members. According to the invention, the electrically conductive contact members are inserted from a side of the body where the IC element is neither mounted nor removed so that the prior art separate member used for seating and positioning the IC package can be omitted, thereby reducing the number of parts and associated assembling steps. The mounting leg of the electrically conductive contact members are engaged in the base in such a manner that they are immovable in the direction of movement of the operating member relative to the socket body, while a base leg of each electrically conductive contact member having a lead for connection to the external circuit is capable of deformation in a direction which is approximately parallel with the direction of movement of the operating member relative to the mounting leg of electrically conductive contact member. In connection with the attachment of an IC package on or removal from the socket body, the connective part for the external circuit is deformed in such a way as to follow the bending of the circuit substrate to which the socket is attached when the substrate is bent concomitant with movement of the operating member. Accordingly, the torsional load upon the joint between the leads of the contact members and the respective connective parts for external circuit of the said substrate is reduced. According to this invention, therefore, it becomes possible to prevent shifting of the contact member leads relative to the connective parts for the external circuit of the circuit substrate, thereby making it possible to offer high conductive reliability.

These and other objects and features of the invention will be apparent from the following description taken with reference to the accompanying drawings.

### Brief Description of the Drawings

Fig. 1 a is a top plan view showing a simplified structure of a socket made according to a first embodiment and Fig. 1b is a front elevational view (partly in cross section) of the Fig. 1a socket;
Fig. 2a is a right side elevational view (partly in cross section) showing a simplified structure of the socket; Fig. 2b is an enlarged, broken away portion P of Fig. 2a; and Fig. 2c is a cross sectional view taken in the X direction of Fig. 2b;
Fig. 3 is a side elevational view of an electrically conductive contact member used in the first embodiment;
Figs. 4a - 4c show a socket (partly in cross section) made in accordance with the invention at progressive steps of assembly;
Fig. 5a is a simplified showing (partly in cross section) of the socket after being assembled, Fig. 5b is an enlarged, broken away portion Q of Fig. 5a; and Fig. 5(c) shows in dashed lines progressive positions of the electrically conductive contact member shown in Fig. 5a being mounted in the socket body;
Figs. 6a and 6b are views similar to Fig. 2a but showing the socket mounted on a circuit board: Fig. 6a showing the cover member in the raised position, and Fig. 6b showing the cover member in the depressed position;
Fig. 7a is an enlarged, broken away cross sectional view of the seating portion of a socket made in accordance with the invention shown with an IC in a skewed position on the seating surface and Fig. 7b is a still further enlargement of portion R of Fig. 7a;
Fig. 8a is a view similar to Fig. 7a but showing the seating portion of a prior art socket shown with an IC in a skewed position with terminals of the IC element received between adjacent contacts of electrically conductive contact members and Fig. 8b is similar to Fig. 7a but showing the incursion of IC terminals among electrically conductive contact members;
Fig. 9a is a partial cross sectional elevational side view showing another embodiment of the invention; Fig. 9b is an enlarged view of portion T of Fig. 9a; and Fig. 9c shows in dashed lines the contact portion of an electrically conductive contact member at progressive steps of assembly;
Fig. 10a is a top plan view of a prior art socket used for burn-in tests of an IC element; Fig. 10b is a front elevational view, partly in cross section, of the Fig. 10a socket; Fig. 10c is a side elevational view, partly in cross section, of the Fig. 10a socket; and Fig. 10d is an enlargement of portion U of Fig. 10c;
Figs. 11a-11d are simplified partial cross sectional views of a prior art socket shown at progressive assembling steps; and
Figs. 12a, 12b are similar to Figs. 6a, 6b, respectively, but showing the effects on the circuit substrate caused by depressing the prior art socket's cover.

### Detailed Description of the Preferred Embodiments

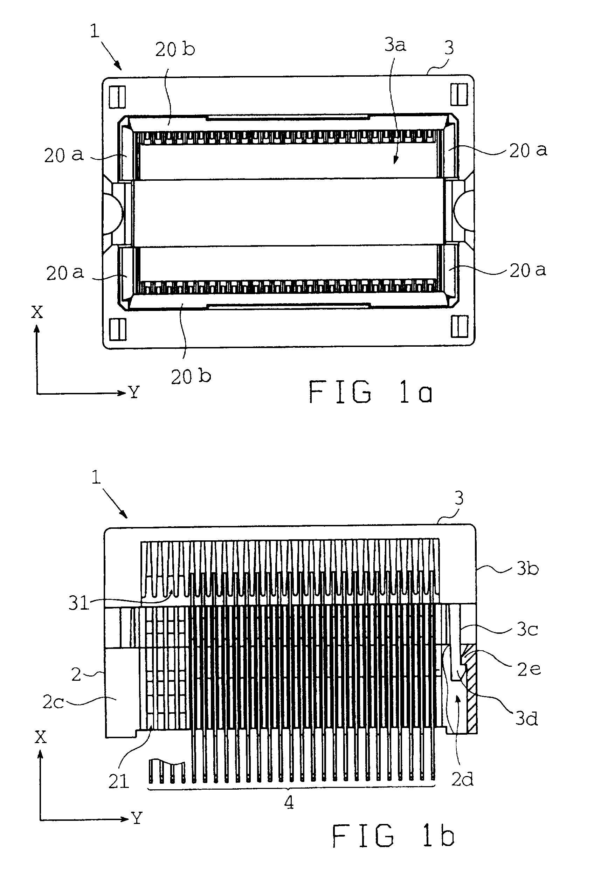

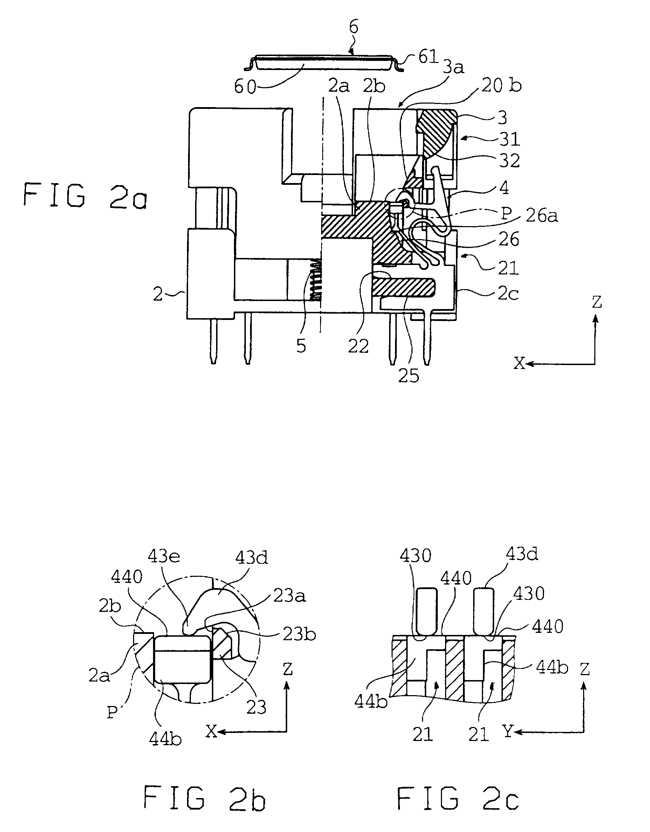

With reference to Figs. 1a, 1b and 2a, socket 1 in the first embodiment is particularly adapted for use with a TSOP (Thin Small Outline Package) and it comprises a base or main socket body 2, an operating cover member 3, electrically conductive contact members 4 and a spring 5. Operating cover member 3 is a generally elongated polygonal frame shaped member made of suitable material such as plastic movably mounted on socket body 2. The socket body is provided with an IC package seating surface 2b formed at the top 2a of base 2 for receipt of IC package 6. IC package 6 has a body 60 in the form of a thin rectangular polyhedron as shown in Fig. 2a. A selected number of IC terminal leads 61 extend out of opposing sides in the lateral direction, as shown in Fig. 2a, of body 60. Guide parts 20a, 20b are formed on base 2 adjacent to the peripheral edge of seating surface 2b for guiding IC package 6 onto the seating surface and are formed with a surface that has been inclined by a selected angle relative to seating surface 2b.

Operating cover 3 has an opening 3a which is somewhat larger than the external configuration of IC package 6. At each comer 3b of operating cover 3, an engagement leg 3c (see Fig. 1b) extends from the main body 3b in approximately a vertical direction. After engagement legs 3c are inserted into holes 2d provided at the corners of base 2, operating cover 3 is movable up and down relative to base 2 limited by hook portion 3d of the legs engaging with catch 2e of the base. As shown in Fig. 2a, operating cover 3 is biased in a direction away from base 2 by means of a spring 5 provided between the base and cover.

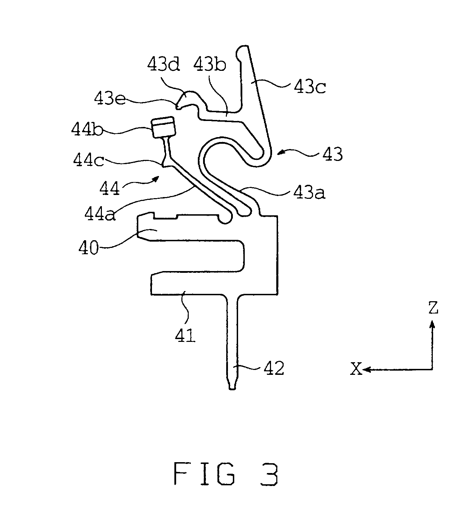

As shown in Figs. 1a, 1b and 2a, a plurality of slots 21 are arranged on opposed sides 2c along the long edge part of base 2 for positioning each contact member. The number and interval of slots 21 are selected to be the same as the number and interval of terminal leads 61 of IC package 6. Guide parts 20b which are formed integrally with base 2 at the top of slots 21 also serve as guard parts to prevent the IC terminal leads 61 from entering and getting entangled in slots 21. As shown in Figs. 2a and 2b, a rib 23 having a positioning surface 23a for positioning the IC package is formed under the guide/guard parts 20b of base 2. Rib 23 is located spaced a selected distance from the edge of seating surface 2b of base 2, to be discussed, which extends somewhat higher than seating surface 2b of base 2. An inclined surface 23b is formed on rib 23 on the outwardly facing side for facilitating the placement of contact member 4 at the top of rib 23. A slot 31 is formed on both sides of the long edge side of operating cover 3 corresponding to the position and shape of each contact member 4. As shown in Fig. 2a, cam surfaces 32 form the closed end of the slots having curved surfaces for camming respective contact members 4. As shown in Fig. 3, each contact member 4 is formed integrally of a thin sheet of electrically conductive, spring metal having a generally U-shaped central portion comprising a first mounting leg 40 capable of engaging with a respective mounting opening 22 of the base as will be described below, and a second base leg 41 flexibly connected to one side of mounting leg 40. When mounting leg 40 of a contact member 4 is fixed to base 22, a respective lead 42 extends from base leg 41 beyond the bottom of base 22 for connection, as by soldering, to a connective terminal 8 on a circuit substrate 7 which will be described below. The location of lead 42 may be placed at various transverse positions on base leg 41, as indicated in Fig. 2a so that the placement of leads 42 can be alternated to facilitate connection with the circuit pattern on substrate 7.

First and second contact parts 43 and 44 are provided on the opposite side of mounting leg 40 from that of base leg 41. First contact part 43 comprises a spring part 43a made by forming that part into a long thin sinuous member extending from leg 40 of the generally U-shaped central portion so as to possess a spring-like property, and having a bifurcated end forming a contact arm part 43b and a lever part 43c. Tip part 43d of contact arm part 43b is formed in the shape of a hook, at whose tip there is formed a first electrical contact 43e, capable of engaging the top of a lead 61 of IC package 6. The second contact part 44 has an arm 44a which extends from mounting leg 40, adjacent to the root of first IC contact part 43, generally toward the first electrical contact 43e. A second electrical contact 44b is formed at the distal tip of arm 44a, capable of contacting the bottom of the same lead 61 of IC package 6. An engagement part 44c at the middle of the arm part 44a of second contact part 44, is formed for positioning and engaging the second contact part 44 relative to base 2. As seen in Fig. 3, second electrical contact 44b is so formed as to be somewhat separated from the first electrical contact 43e when contact member 4 is not mounted on base 2. As shown in Figs. 2b and 2c, the second electrical contact 44b of contact member 4 is formed so that the distal tip is increased in the thickness direction (the direction of arrow Y in Fig. 2c) of contact member 4 to make the width of the contact surface 440 of the second electrical contact 44b larger than the width of contact surface 430 of first electrical contact 43e and, at the same time, to be approximately equal to the width of the slot part 21 of base 2. It is desirable in this connection that the width of the contact surface 440 of the second electrical contact portion 44b be set in the range between 0.5 and 0.7 times the pitch of contacts 4.

With reference to Fig. 2a, a guide surface 26 is formed in a portion of slot 21 disposed above hole 22 for guiding second IC contact part 44 in connection with mounting contact members 4 in base 2. An engagement step 26a is formed intermediate to the ends of guide surface 26, which is capable of engaging with engagement part 44c of second contact part 44 of contact member 4. Because of the engagement between engagement step 26a and engagement part 44c of second contact part 44 of contact member 4, contact surface 440 of the second electrical contact 44b is positioned to lie approximately in, or slightly below, the same plane in which the opposing surface 2b of base 2 lies.

As shown in Fig. 2a and as noted above, there is formed in the lower portion of slot 21 of base 2, a respective mounting hole 22 for each contact member which extends transversely in a direction that crosses the direction of movement of operating cover 3, indicated by an arrow head Z, for reception of leg 40 of contact member 4. Each mounting hole 22 of base 2 is formed to be slightly smaller than the outside shape of leg 40 of contact members 4 which are pressed into the mounting holes. Support leg 41 which extends in parallel with leg 40 is disposed in slot 21 at a position at the bottom of base 2. The spacing between legs 40, 41 is selected to be slightly less than the thickness of base 2 between mounting holes 22 and the bottom of slot 21. When leg 40 of a contact member 4 is inserted into a respective mounting hole 22 of base 2 as described above, the legs are caused to flex apart forming a gap (for example, approximately in the range between 0.05 mm. and 0.1 mm.) between the lower face 25 of the base in the slot and the upper surface of leg 41 of the contact member.

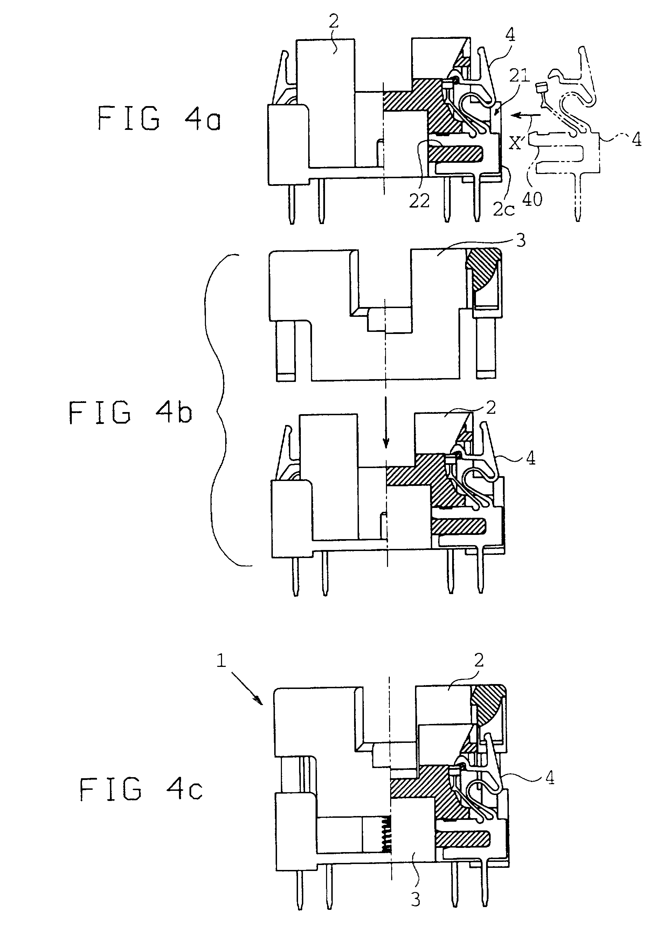

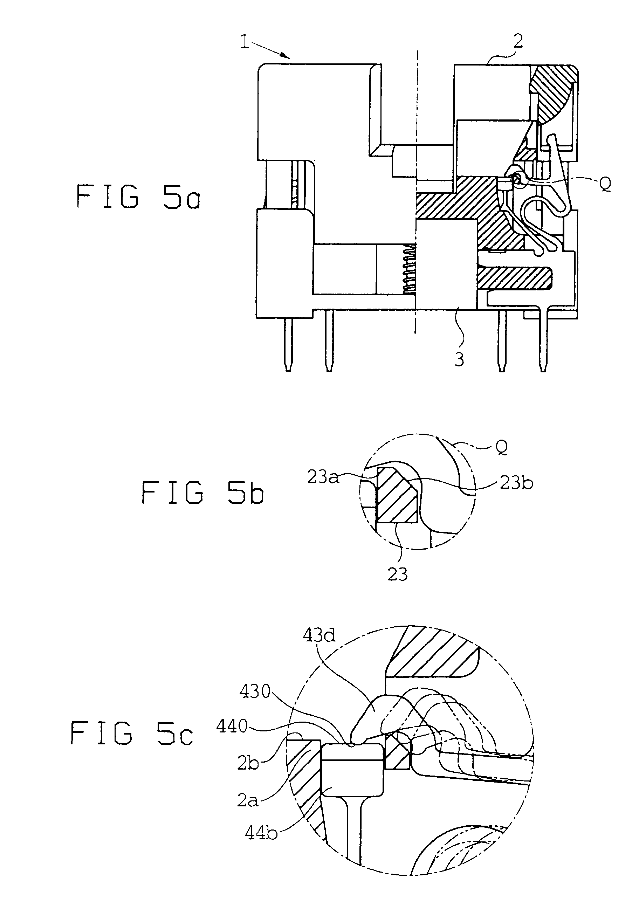

Next, the method for the assembling of the socket made in accordance with this embodiment will be explained below referring to Figs. 4a through 4c and Figs. 5a through 5c. First, each contact member 4 is inserted into a respective slot 21 of base 2 from side 2c of the base, the contact member being moved in the transverse direction indicated by an arrow X, and its mounting leg 40 is compressively inserted into mounting hole 22 of base 2. By repeating this step, a selected number of contact members 4 are fixed to base 2. According to the embodiment, guide surface 23b, Figs. 5b and 5c, that has been inclined by a selected angle, is formed on rib 23 with positioning surface 23a extending above the plane in which contact surface 440 lies. When contact member 4 is inserted into base 2, first electrical contact 43e rides on inclined guide surface 23b of rib 23 as indicated by the several dashed lines in Fig. 5c, thereby smoothly effecting the selected placement. In connection with mounting contact members 4, moreover, second contact parts 44 are guided by the guiding surfaces 26 of base 2 and the second electrical contacts 44b are inserted between the top 2a of base 2 and rib 23.

Next, operating cover 3 is installed from above base 2 as shown in Fig. 4b, thereby completing socket 1 of the embodiment as shown in Fig. 4c.

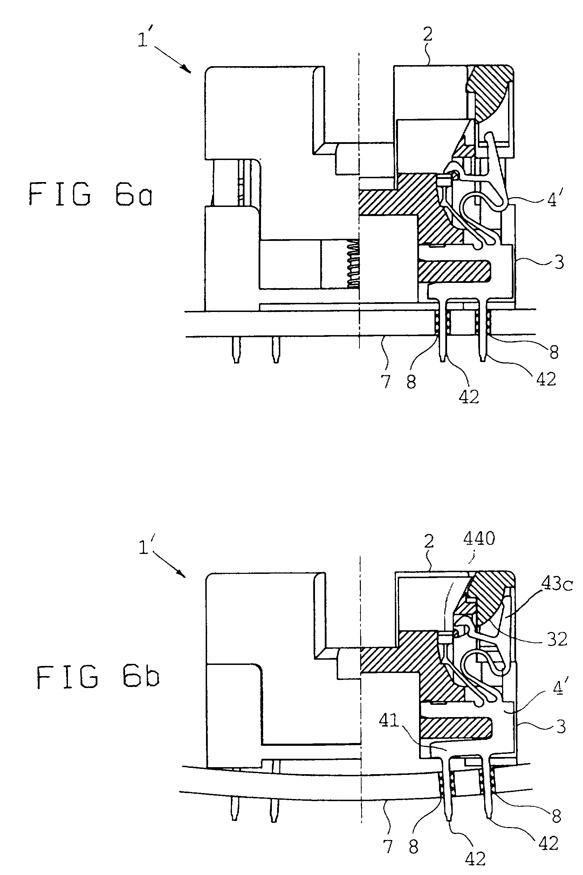

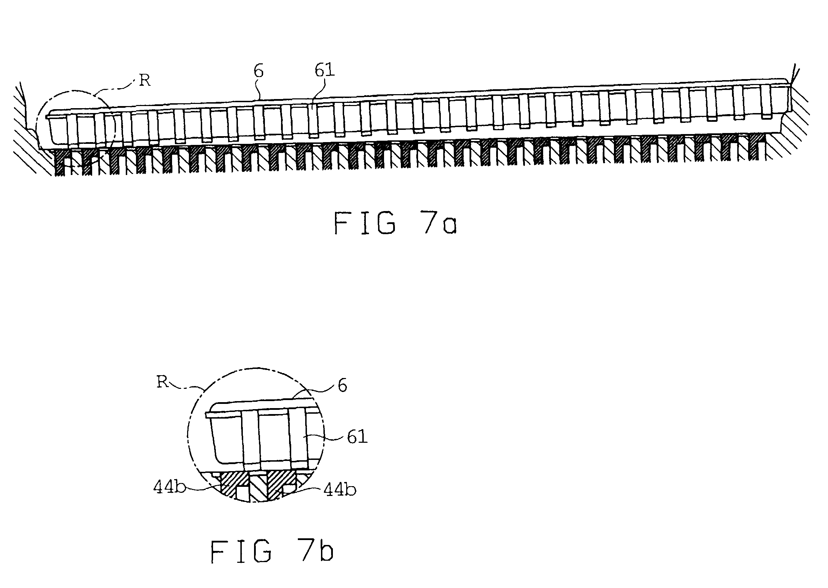

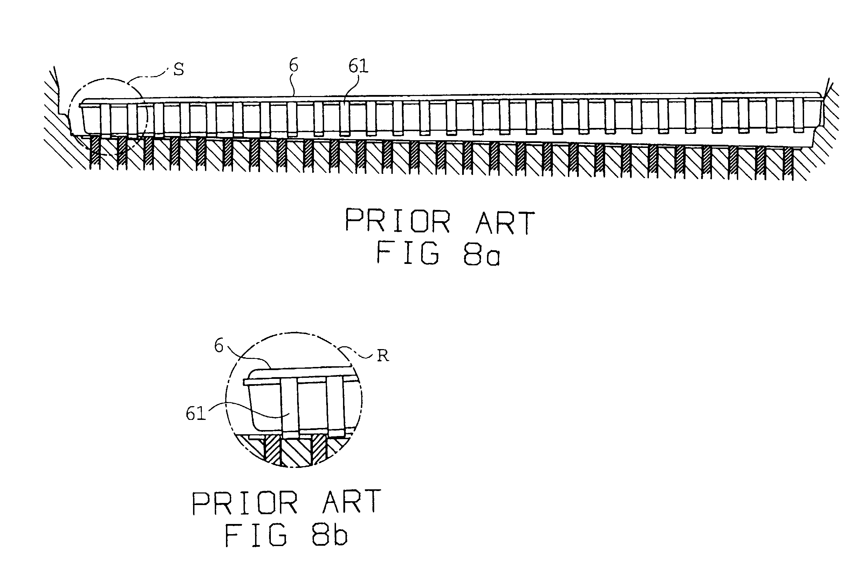

As shown in Fig. 6a, socket 1' in this modified embodiment is mounted on circuit substrate 7 and has contact members 4' with two leads 42 soldered to connective terminals 8 of the circuit board. When operating cover 3 of socket 1 is pressed down as shown in Fig. 6b, cam surface 32 of operating cover 3 engages the follower tip of lever part 43c of contact member 4' and if the operating cover is further pressed down, lever 43c of contact member 4' is cammed along cam surface 32 of operating cover 3. Along with this, first electrical contact portion 43e moves in a direction away from the second electrical contact 44b so that lead 61 (Fig. 2a) of IC package 6 can be placed on contact surface 440 of second electrical contact 44b of contact member 4'. In this case circuit substrate 7 bends as operating cover 3 is pressed down. As shown in Fig. 6b, however, the flexible connection of leg 41 of contact member 4' undergoes an elastic deformation in conformity with the bending of circuit board 7 so that the torsional load on the soldered connection between leads 42 of contact member 4' and connective terminals 8 of board 7 is reduced and shifting of leads 42 of contact member 4' can be prevented. In this embodiment, as well as the embodiment shown in Fig. 2b, the width of the second electrical contact 44b of the contact member has been increased in the direction of the thickness of the contact member with a result that should the IC package 6 not be properly seated, as shown in Figs. 7a and 7b, there will be no encroachment of leads 61 of IC package 6 between the second contacts 44b of the type possible in the prior art illustrated in Figs. 8a and 8b, making it possible for the IC leads to be firmly placed on the contact surfaces 440 of second contacts 44b.

When there is no downward force on the operating cover 3, the cover is pushed up by the spring forces of spring 5 and contact members 4. In conformity with this, each IC package terminal lead 61 is sandwiched by first electrical contact portion 43e and second electrical contact 44b of a respective contact member 4, with a consequence that the respective contact member 4 and IC package terminal lead 61 are electrically connected.

According to the embodiment, contact member 4 is formed for compressive insertion into socket 2 from side 2c. Accordingly, the prior art adaptor whose purpose it is to position the IC package can be omitted. Therefore, the number of parts and the assembly steps involved can be reduced.

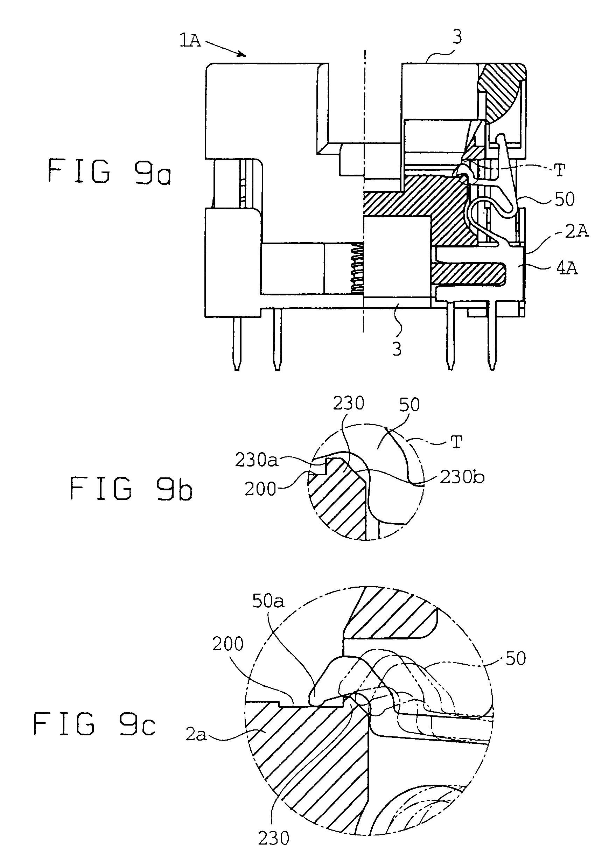

Figs. 9a through 9c are partial cross sections showing a socket made according to another embodiment of the invention. Those components which correspond to like components of the previously described embodiments will be given the same reference characters and their detailed explanations will be omitted. Socket 1A in this embodiment employs a contact member 4A that has a single contact part 50. In this embodiment, a seating surface 200 for seating IC package 6 is formed at the top 2a of base 2A and a positioning surface 230a of a protrusion 230 used for positioning an IC package 6 is formed integrally with the edge of base 2A. An inclined guide surface 230b of protrusion 230 is formed at a selected angle at a position on the side of base 2A for mounting contact 4A and positioning surface 230a extends higher than seating surface 200 as in the first embodiment described above. In the present embodiment, contact 50a rides up on the inclined guide surface 230b of protrusion 230 as indicated by the dashed line positions in Fig. 9c in connection with the compressive mounting of contact member 4A, with a result that it is positioned at a suitable location for making contact with lead 61 of an IC package 6.

According to this embodiment, it becomes possible to reduce the number of parts and the assembly steps as in the first described embodiment. In addition, as in the first embodiment, since IC leads 61 of the IC chip 6 are received directly on seating surface 200 of base 2A, there is accordingly an advantage in that it becomes possible to support the IC lead 61 of the IC chip 6 on a flatter surface. The other features, effects and functions are the same as in the first described embodiment; therefore, their detailed explanations will not be repeated here.

The invention is not intended to be limited to the above described embodiments but can be modified in various ways. For example, in the above described embodiments, the mounting leg of the contact member is compressively inserted into the mounting hole provided in the side of the base. According to the invention, however, various mounting schemes can be used as long as the contact member is mounted so that it will not move in the direction of movement of the operating cover. Further, the invention can be used to accommodate IC chips for burn-in tests and for the measurement of various electric properties of various IC chip packages such as, for example, a TSOP (Thin Small Outline Package) and a QFP (Quad Flat Package), etc.

According to the invention described above, the prior art adaptor member, deemed necessary for positioning an IC package can be omitted. Thus, the number of parts and assembling steps involved can be reduced. According to this invention, further, it becomes possible to prevent a shift of the connecting part for the external circuit relative to the circuit substrate, with a result that improved continuity reliability can be obtained. According to the invention, moreover, it becomes possible to effect a connection between the socket and an electrically conductive member on a more reliable basis by means of electrically conductive contact members each having a pair of electrical contacts for making electrical engagement by sandwiching a respective connective terminal of the electric element.

It should be understood that it is the intention that the invention includes all modifications and equivalents of the described embodiments falling within the scope of the appended claims.

## Claims

1. A socket for connecting terminals of an electrical element to an external circuit substrate through electrically conductive contact members comprising an electrically insulative base, the base having a top on which is formed a seating surface, a bottom and a side, a positioning member for positioning the electrical element on the seating surface, an electrically conductive contact member for each terminal of the electrical element, a mounting hole for each electrically conductive contact member extending transversely into the base from the side of the base and communicating with a slot extending up to the top of the base, each contact member having a central portion with a movable contact part having a free end portion having an electrical contact, the movable contact part extending upwardly from the central portion, the central portion comprising a laterally extending mounting leg and an elongated lead extending downwardly from the central portion, the mounting leg of a respective contact member received in a respective mounting hole of the base with the respective contact part disposed in the respective communicating slot and with the contact disposed adjacent to the seating surface and with the elongated lead extending downwardly beyond the bottom of the base for connection to the external circuit substrate..

2. A socket according to claim 1 further comprising an operating member mounted on the base for movement relative to the base, each electrically conductive contact member having an operating member engagement surface which engages a portion of the operating member and is moved in response to movement of the operating member, the central portion of each contact member having a second laterally extending base leg flexibly connected to the respective mounting leg in a generally U-shaped configuration, the elongated lead extending downwardly from the second laterally extending base so that flexing movement of the circuit substrate relative to the socket will be transferred to the second laterally extending base leg through the respective lead causing the second laterally extending base leg to move relative to the laterally extending mounting leg.

3. A socket described in claim 2 in which the operating member moves in two opposite directions and the transversely extending mounting hole of the base extends in a direction which crosses, approximately at a right angle, the directions in which the operating member moves and the mounting leg of each electrically conductive member forms an interference fit with the mounting hole of the base.

4. A socket according to claim 2 in which the second laterally extending base leg of each electrically conductive contact member is connected to the mounting leg through a connective portion which is capable of elastic deformation in a direction which is approximately in parallel with the directions of movement of the operating member.

5. A socket according to claim 1 further comprising an incursion preventative part formed on the base for preventing incursion of an electrical element terminal between adjacent electrically conductive contact members.

6. A socket according to claim 1 in which each electrically conductive contact member has a first and second electrical contact part, each having a free end portion formed with an electrical contact for engaging a respective electric element terminal in such a way as to sandwich the respective terminal of the electric element.

7. A socket according to claim 6 in which the electrically conductive contact members are arranged side by side in a row in the base and one of the first and second electrical contact part of each contact member is disposed so that the respective electrical contact receives thereon a respective electric element terminal, the electrical contact on which each terminal is received having a width taken in the direction of the row which is greater than the remainder of the respective contact member.
